Europäisches Patentamt

(19) European Patent Office

Office européen des brevets

(11) Publication number: **0 102 180**
**B1**

(12) **EUROPEAN PATENT SPECIFICATION**

(45) Date of publication of patent specification: **08.10.86**

(21) Application number: **83304225.2**

(22) Date of filing: **21.07.83**

(51) Int. Cl.⁴: **H 01 R 13/193,** H 01 R 23/68, H 05 K 7/10

(54) Connector.

(30) Priority: **23.07.82 US 401176**
**16.06.83 US 504916**

(43) Date of publication of application:
**07.03.84 Bulletin 84/10**

(45) Publication of the grant of the patent:
**08.10.86 Bulletin 86/41**

(84) Designated Contracting States:
**AT BE CH DE FR GB IT LI NL SE**

(56) References cited:
**EP-A-0 050 442**
**US-A-3 783 429**
**US-A-3 861 030**
**US-A-4 220 389**

(73) Proprietor: **RAYCHEM CORPORATION**
**300 Constitution Drive**
**Menlo Park California 94025 (US)**

(72) Inventor: **Hine, Jean-Patrick**
**253 Oakview Drive**
**San Carlos California 94070 (US)**
Inventor: **McGaffigan, Thomas Haynes**
**326 La Espiral**
**Orinda Caliofrnia 94563 (US)**

(74) Representative: **Jones, David Colin et al**
**Raychem Limited Intellectual Property**
**Law Department Swan House**
**37-39 High Holborn**
**London WC1 (GB)**

Courier Press, Leamington Spa, England.

## Description

The present invention relates to a connector, and in particular, although not exclusively, to a connector suitable for the connection of devices to circuit boards.

Connection of semiconductor devices, such as integrated circuits, has become increasingly difficult as the number of pins on the device increases. An example of such a device is a pin grid array package having a plurality of pins which plug into holes in a printed circuit board so that a reliable soldered connection can be made. Such solder connections provide good electrical contact and have good mechanical properties. However, a soldered connection is in essence a permanent connection and it is often difficult to remove such a package without damaging it or the board.

In order to provide a removable connection, it is common to pre-attach a spring-loaded retaining socket to the circuit board and to rely on the spring characteristics of the socket to retain the components in place. As the number of pins in a package increases, the amount of force required to overcome the cumulative resistance of a corresponding number of sockets may be so great that either the package, the circuit board, or both becomes damaged by insertion or removal of the package.

U.S.—A—3,763,459 describes a plug-in type socket for making temporary electrical connections with such packages without applying substantial insertion pressure. Mechanical actuation of a plurality of contact elements is effected by a single actuating means. U.S.—A—3,315,212 describes a multi-pin connector assembly, including a cam-actuated movable connect or block mounting flexible contacts. The problem of the above-mentioned devices is that the mechanical retaining force is not always satisfactory, particularly where the devices are exposed to shock or vibration. As a result, the devices are used only for the temporary testing and evaluating of packages.

E.P.—A—0,050,442 describes a connector for connecting an array of pins on a substrate to a printed circuit board. The connector comprises a housing and a cover that is slidably positioned on the housing. The housing contains a plurality of electrical contacts and the cover contains a plurality of openings into which the contacts extend. The cover can be moved using a rotable tool such as a screwdriver tip to open the contacts and receive the pins. When the tool is removed a spring mechanism in each contact causes the contacts to close against the pins to make electrical contact therewith.

U.S.—A—3,783,429 describes a device for connecting an individual conductor to a printed circuit board. The device comprises a first heat-recoverable metal alloy member and a second spring member. The two members are arranged such that when the first member changes from a martensitic state to an austenitic state it causes the second spring member to move and either engage with or disengage from the printed circuit board.

U.S.—A—3,240,839 describes an extremely reliable contact which can be pre-soldered into a printed circuit board and which exerts a very strong retaining force on electrical components such as pins, after they are installed. The contact comprises a resilient member, preferably as a forked member formed from beryllium copper, having two or more tines capable of being moved inwardly. The tines when so moved, exert an outward force on the means which is moving them inwardly. A band of heat-recoverable metallic material, for example, of a suitable alloy of titanium nickel, is placed around the exterior of the tines. When the metallic band is at a first temperature, it will be in its austenitic state, during which state it will have substantial strength and will attempt to assume a small diameter condition. This has the result that the tines will be pressed inwardly against any object inserted between them. Commonly assigned U.S.—A—3,861,030 uses a plurality of these individual contacts mounted with a plurality of tabs depending from an elongated carrier strip. As the number of contacts increases, the complexity and the cost of such a connector increases dramatically.

A first aspect of the invention provides a connector comprising a first board and second board each having a plurality of openings formed therethrough, the second board being mounted generally parallel to the first board such that the openings in the first board are complementary to the openings in the second board, and a motion-transmitting means of heat-recoverable metal having a martensitic state and an austenitic state, the means being expanded dimensionally while in its martensitic state, such that a change from its martensitic state to its austenitic state recovering the means to its non-expanded dimension, moves the boards relative to each other, the relative movement of the boards effecting engagement or alternatively disengagement of insertable elements that may be inserted into the complementary openings of the boards.

Heat recoverable metals are disclosed in U.S.—A—3,012,882 and U.S.—A—3,174,851, and Belgian BE—A—703,649. As made clear in these patents, they alloys undergo a transition between an austenitic state and a martensitic state at certain temperatures. When they are deformed while they are in the martensitic state, they will retain this deformation while maintained in this state, but will revert to their original configuration when they are heated to a temperature at which they transform to their austenitic state. This ability to recover upon warming has been utilized in U.S.—A—4,035,007 and U.S.—A—4,198,081. The temperatures at which these transitions occur are affected, of course, by the nature of the alloy. A group of alloys having a particularly useful transition temperature are disclosed in U.S.—A—3,753,700 and U.S.—A—4,337,090.

The heat-recoverable metal motion transmission means may be fabricated from a heat recoverable metal material, for example, the titanium nickel alloy disclosed in U.S.—A—3,753,700.

The connector of the present invention may be used, for example, for connecting insertable elements, for example electrically conductive members such as a plurality of closely spaced pins, and a substrate having contact elements. The connector may advantageously and conveniently be arranged to provide high retention force and a low or zero insertion force. In one embodiment the connector may be arranged such that relative movement of the boards effects engagment between insertable elements that may be inserted into the complementary openings of the boards, when the metal transforms from its martensitic state to its austenitic state. In an alternative embodiment the connector may be arranged such that relative movement of the boards effects disengagement with insertable elements.

The connector can advantageously form a strong physical connection with the insertable elements, such as the pins of a multipin module, and the contacts of a substrate without applying the force in such a way that would bend or otherwise damage the pins or contacts.

The connector can also advantageously be extremely compact and have a minimum number of components.

Another advantage is that the connector may be arranged to be reusable for removable interconnection of insertable elements.

The connector of this invention advantageously comprises a compact assembly for mounting, and preferably releasably connecting an array package wherein the device provides high retention force and a low insertion force. The number of insertable elements in the form of pins in such a package (usually more than one hundred) make interconnection impossible if the individual contacts in the connector have a high pressure contact force. Generally a compromise as to contact force is necessary thus destroying the integrity of the device during vibration, or after the package is exposed to ambient conditions such as high humidity or salt spray. Because the speed of the signals transmitted in such packages is high, no signal interruption larger than a nanosecond is acceptable. During environmental conditions such as high vibration, this requirement is difficult to achieve with conventional connector designs. The use of a heat-recoverable metal having two phases allows the design of a connector which may have low insertion force and yet have high retention force. The present invention advantageously provides a connector using heat-recoverable metals to provide a low insertion force and high retention force in an extremely compact package having a minimum number of moving parts.

In a preferred embodiment the motion transmitting means comprises a grid having webs of material extending between a first and second end of the grid defining at least one slot between the webs, the openings of the first and second boards being positioned so as to define engagement paths between the webs, the first end of the grid being connected to the first board and the second end of the grid being connected to the second board. The grid preferably comprises a plurality of webs and slots. In a preferred embodiment the grid is sandwiched between the boards.

The boards can conveniently be made by injection-moulding, and the grid by machine stamping. The boards are preferably low profile and the grid flat. Thus economic processes can be used to produce a compact and reliable connector having a minimum number of components for securely but removably connecting, for example an array package, to a substrate.

The connector can thus be made both physically and electrically compact. The connector may have a low profile and a minimum plan surface area that facilitates high packing densities. The combined pin and contact length is at a minimum, thus the length of the signal transmission path is short facilitating high signal transmission speeds.

Where the motion transmission means comprises a grid the grid is preferably sandwiched between the boards. Other arrangements are possible where the motion transmitting means is connected outward of the boards, that is it is mounted externally of the boards. In one embodiment the externally mounted motion transmission means comprises a linear element. The motion transmitting means may be of various cross-section. For example where the means is a grid it may have webs of different cross section. Where the means is a linear element a portion preferably has a reduced axial cross-section. The non-uniformity in cross-section may advantageously be arranged to promote even stress distribution within the motion transmitting means and may also be arranged to optimise the heat-recoverable strain behaviour of the heat recoverable metal. Even stress distribution within the grid accommodates for example uneven pin distribution in an array package. In another embodiment the motion transmitting means comprises a spring — C-ring captured by a heat-recoverable ring acting as the heat-recoverable metal transmitting means to compress the C-ring and thus move one board relative to another for engagement. Upon change of metallurgical state, the spring force generated by the C-ring overcomes the heat-recoverable ring to disengage the pins of the multipin module.

In a preferred embodiment the connector of the present invention comprises an opening means inter-connecting the boards to bias the first board relative to the second board to disengage insertable elements that may be inserted into the complementary openings of the boards when the heat-recoverable metal transforms from its austenitic to its martensitic state.

An opening means is advantageously provided in a connector having a motion transmitting means arranged to move the boards relative to each other so as to engage insertable elements.

In another preferred embodiment the connector comprises a closing means interconnecting the boards to bias the first board relative to the second board to engage insertable elements that may be inserted into the complementary openings when the heat-recoverable metal transforms from its austenitic to its martensitic state.

A closing means is advantageously provided in a connector having a motion transmitting means arranged to move the boards relative to each other so as to disengage the insertable elements.

In one embodiment where an opening means is included the opening means may comprise a tool removably connected to the motion transmitting means to expand the motion transmitting means when the heat-recoverable metal goes from its austenitic to its martensitic state. Simultaneously with application of the tool the heat-recoverable motion transmitting means is preferably cooled causing it to change metallurgical state and thus allow release of the insertable inserts.

When the connector is arranged such that recovery of the metal motion-transmitting means causes engagement of the insertable elements inserted in the connector, the tool preferably comprises first and second members that are arranged thermally and mechanically to engage the heat-recoverable metal of the connector, and are capable of being cooled, and an expansible biasing means interconnecting the members, cooling of the members of the tool causing cooling of the metal of the connector such that the biasing means can expand to move the members apart from each and thereby expand the heat-recoverable metal.

For a connector arranged such that recovery of the metal motion transmitting means causes disengagement of insertable elements inserted in the connector a similar separate tool with a contractible biasing means arranged to bias the members towards each other could be used to close the connector.

The opening means and the motion transmitting means may be integral, for example, the motion transmitting means may be made from a trained heat-recoverable metal which reversibly transforms from its recovered austenitic state to its expanded martensitic state upon change in temperature to disengage the insertable elements. Similarly the closing means and the motion transmitting means may be integral, for example using a trained heat-recoverable metal which reversibly transforms to engage the insertable elements.

Where the heat-recoverable metal motion transmitting means is arranged to close the connector, the connector may in a preferred embodiment have surface areas which coact with the insertable inserts to translate and to amplify the insertion force of the insertable elements when such elements are inserted into the boards so as to bias the motion transmitting means to open the conductor. The opening means may comprise inclined contact surfaces in one of the boards, the surfaces being complementary to the openings in that board, the surfaces defining a means for translating and amplifying the insertion force of insertable elements when inserted into the openings to bias the first board relative to the second board when the heat-recoverable metal is in its martensitic state, expanding the heat-recoverable metal motion transmitting means.

In another embodiment the opening means may comprise a separate biasing means to bias the motion transmission means for disengagement. The separate biasing means may be made integrally with one of the boards or with individual contact elements when contained within the board.

In a preferred embodiment the connector comprises contact elements associated with, preferably connected to one of the boards, the contact elements being complementary to the openings in the other board. In a particularly preferred embodiment the contact elements act as a biasing means to bias the boards relative to each other to disengage insertable inserts that may be inserted into the openings of the other board when the heat-recoverable metal transforms from its austenitic to martensitic state.

Thus in the preferred embodiment the connector is provided with internal electrical contacts to perform a biasing function to open the conductor. To provide the connector with contacts is also advantageous where the contacts are provided in order to engage insertable elements e.g. pins of an array package, since the contacts may provide some compliance. In one embodiment the contact elements are bifurcated. Bifurcated elements may advantageously be arranged to provide a strong contact force. The contact elements are preferably compliant.

The opening means may comprise a split ring spring-like member. This may be arranged with respect to a ring like motion transmitting means mounted externally of the boards such that the motion transmitting means surrounds the opening means. In another embodiment spring like opening means are arranged concentrically relative to a linear motion transmitting means mounted externally of the boards.

Where the heat-recoverable metal motion transmitting means is arranged to open the connector a separate closing means may be provided. This may be in the form of a single spring like member that contacts the boards. Where the motion transmitting means is a linear element the spring like member is preferably mounted concentrically thereto. Other closing means may be used, for example individual contacts arranged to bias the boards and to make electrical and mechanical contact.

In another embodiment of the present invention, the connector comprises a third board, having a plurality of openings therethrough, the third board being mounted parallel to the second board such that the openings in the third board are complementary to the openings in the second board, and a second motion transmitting means of heat-recoverable metal interconnecting the second and third boards to move the boards relative to each other.

In another embodiment of the present invention, the connector comprises a third board having a plurality of openings formed therethrough, the third board being mounted parallel to the second board such that the openings in the third board are complementary to the openings in the second board, the third board being connected to the first board such that recovery of the motion transmitting board moves the first and third board relative to the second board.

A second aspect of the present ivnention provides a kit of parts for forming a connector comprising a first board and a second board, each having a plurality of openings formed therethrough, the boards being mountable generally parallel to each other so that the openings in the first board are complementary to those in the second board, and a motion transmitting means of a heat-recoverable metal having a martensitic and an austenitic state, the means being expanded dimensionally while in its martensitic state and being positionable relative to the boards such that a change from the martensitic to the austenitic state of the means recovering the means to its non-expanded dimension, causes the boards to move relative to each other, the relative movement of the boards effecting engagement or alternatively disengagement of insertable elements that may be inserted into the complementary openings of the boards.

Embodiment of the present invention will now be described, by way of example, with reference to the accompanying drawings, wherein:

Figure 1 is an exploded view of an unassembled connector embodying the present invention with an array package positioned above the connector and an optional biasing means shown in phantom;

Figure 2 is a cross-sectional view taken along section line 2—2 of Figure 1 showing the package positioned within the assembled connector prior to engagement with the pins of the package;

Figure 3 is a cross-sectional view corresponding to Figure 2 after engagement with the pins of the package;

Figure 4 is a cross-sectional view similar to Figure 3 or an alternative embodiment of connector according to the present invention;

Figure 5 is a side view of the connector of Figures 1 to 3 or Figure 4 and an installed package, and a removal tool for opening the connector; placed in position but prior to operation of the tool;

Figure 6 is a side view similar to Figure 5 after operation of the removal tool;

Figure 7 is a partial cross-sectional view of another alternative embodiment of connector according to the present invention, having a self-biasing contact element;

Figure 8 is a partial cross-sectional view similar to Figure 2, of a further embodiment of connector according to the present invention in its closed position;

Figure 9 is a cross-sectional view of the connector of Figure 8 and of an array package positioned over the connector, with the connector in its open position;

Figure 10 is a cross-sectional view corresponding to Figure 9 after engagement of the connector;

Figure 11 is a cross-sectional view similar to Figure 2, of a further alternative embodiment of connector according to the present invention, with the connector in its closed position;

Figure 12 is a cross-sectional view of the connector of Figure 11 and of an array package positioned over the connector, when the connector is in its open position;

Figure 13 is a cross-sectional view corresponding to Figure 12 with the connector in its closed position;

Figure 14 is a cross-sectional view similar to Figure 2 of yet another embodiment of connector according to the present invention and of an array package positioned over the connector with the connector in its closed position;

Figure 15 is a cross-sectional view corresponding to Figure 14, illustrating insertion of the pins of the package;

Figure 16 is a cross-sectional view corresponding to Figure 15 with the connector closed;

Figure 17 is a partial cross-sectional view similar to Figure 2 of yet another embodiment of connector according to the present invention, having an externally mounted heat-recoverable metal motion transmitting means and biasing means;

Figure 18 is a perspective, partially cross-sectioned view of yet another embodiment of connector according to the present invention illustrating an outboard motion-transmitting means of non uniform cross-section and a bifurcated contact element;

Figure 19 is a partial cross-sectional view taken along section line 19—19 of Figure 18, illustrating a zero-insertion-force device using a bifurcated contact design prior to engagement with an insertable element;

Figure 20 is a partial cross-sectional view corresponding to Figure 19 after engagement of the contact element with the insertable element;

Figure 21 is an exploded view similar to Figure 1 of yet another embodiment of connector according to the present invention having a motion-transmitting means comprising a grid having webs of varying cross-section;

Figure 22 is a partially cross-sectioned perspective view used to illustrate two further embodiments of connector according to the present invention;

Figure 23 is a partial cross-sectional view taken along section lines A—A of Figure 22 illustrating the connector in an open position;

Figure 24 is a partial cross-sectional view corresponding to Figure 23 with the connector in a closed position;

Figure 25 is a partial cross-sectional view of an alternative embodiment taken along section line A—A of Figure 22 with the connector in a closed position;

Figure 26 is a partial cross-sectional view corresponding to Figure 25 with the connector in an open position;

Figure 27 is a cross-sectional view of another embodiment of connector according to the present invention positioned over a substrate having insertable elements in the form of substrate contact elements;

Figure 28 is a cross-sectional view corresponding to Figure 27 with the connector placed on the substrate;

Figure 29 is a cross-sectional view corresponding to Figure 28 including an array package after engagement of the connector with the insertable elements;

Figure 30 is a cross-sectional view similar to Figure 2 but of an alternative embodiment of the connector according to the present invention positioned over a substrate;

Figure 31 is a cross-sectional view corresponding to Figure 30 with the connector placed on the substrate but before engagement of the connector; and

Figure 32 is a cross-sectional view corresponding to Figure 31 including an array package after engagement of the connector to the insertable elements.

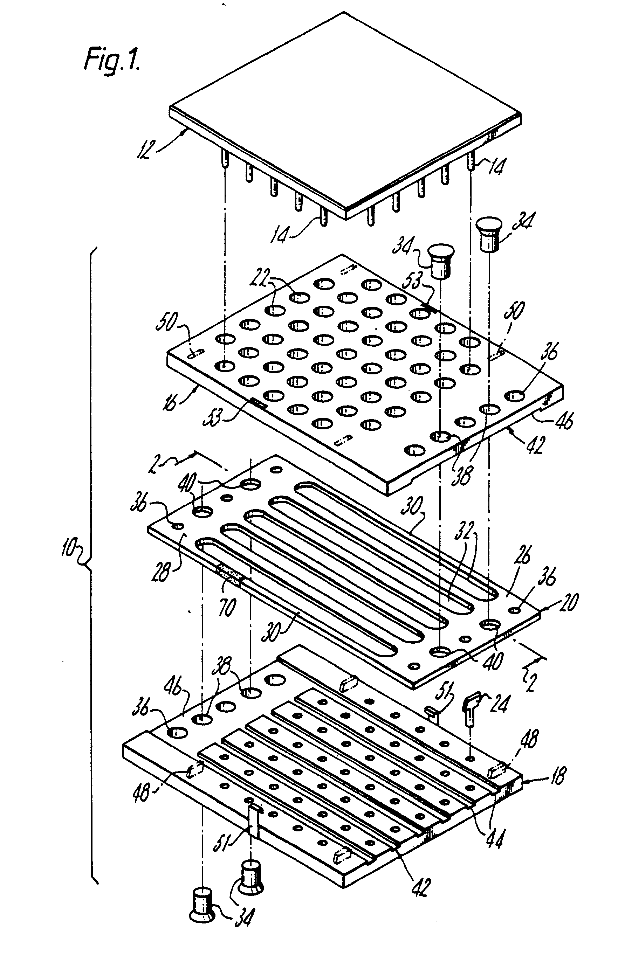

Referring to the drawings Figure 1 illustrates a connector referred to generally at 10 and positioned above the connector 10 a pin grid package shown generally at 12. The connector 10 comprises a first board 16, a second board 18 and a heat-recoverable metal motion transmitting means in the form of a grid 20 positioned between the boards 16, 18. A plurality of pins 14 extend from the pin grid array package 12. Pins 14 are called insertable elements. The pins 14 may be arrayed in a variety of geometric configurations and may be of various cross sections.

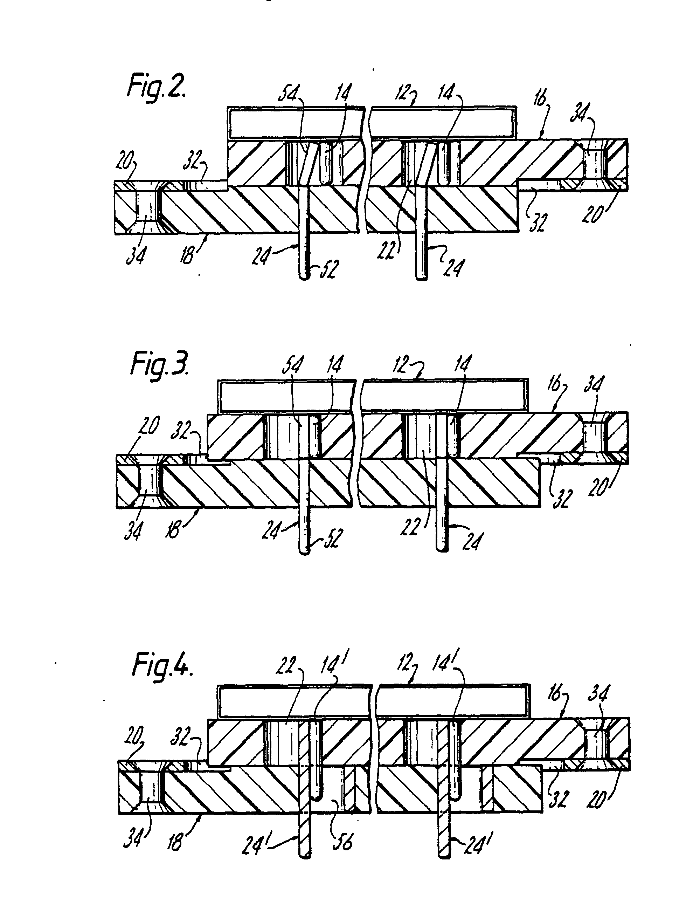

The first board 16 of the connector 10 contains a plurality of openings 22 formed through the boards. The openings 22 are complementary in number and array to the pins 14 of the package 12. The second board 18 contains a plurality of openings through the board, containing contact elements shown typically by contact element 24. The contact elements 24 are complementary in array and compatible in size to the openings 22 and, when the connector is assembled extend into the openings 22 (Figures 2 and 3). The contact elements 24 constitute insertable elements. The contact elements 24 are designed to be compliant, as to the pins 14. The openings 22 are sufficiently large to accommodate the contact elements 24 and the pins 14.

The grid 20 causes engagement between the insertable elements 24 that may be inserted into the openings in the boards 16, 18. The grid 20 has a first end 26, a second end 28, and webs 30 which extend between the first and second ends 26 and 28 define slots 32 between the webs 30.

The grid 20 is positioned between the first board 16 and the second board 18. The slots 32 are wider than the width of the openings 22 and the contact elements 24 so as to be insulated from the contact elements 24 and the pins 14 that may be inserted into the openings 22. The first end 26 of the grid 20 is connected to the first board 16 and the second end 28 of the grid 20 is connected to the second board 18 by fastener means 34 in the form of rivets 34. Other fastening means including integral moulding of the grid within the boards 16, 18 may be used.

Tool openings 36 are provided in the grid 20 and in the frist and second boards 16 and 18 to accommodate an opening means. Fastener means 34 are staggered with respect to tool openings 36 and extend through holes 38 in the boards 16 and 18, into holes 40 in the grid 20. The fastener means may act as a tool connection. For example, the fastener means 34 may comprise hollow rivets (not shown) into which the tool may be inserted. Such an arrangement allows uniform stress distribution within the grid 20 during expansion.

Boards 16 and 18 preferably have recesses to insulate and slidingly receive webs 30 of the grid 20. The recesses area noted generally by 42 can be clearly seen with respect to the second board 18. The underside of first board 16 cannot be seen in Figure 1, but its recessed area is identical to that of the second board 18.

The recess 42 in turn comprises channels 44 and an open portion 46. The channels 44 accommodate webs 30 and open portions 46 accommodate the first and second ends 26 and 28 of the grid 20.

Figure 1 also illustrates in phantom an opening means in the form of alternate resilient members 48 mounted to the upper surface of the second board 18 and complementary interfaces 50 within the lower surface of the first board 16. The resilient members 48 and complementary interfaces 50 define a separate biasing means which biases the first board 16 relative to the second board 18 to disengage the pins 14 when the grid 20 no longer overcomes the forces created by the biasing means. Such a separate biasing means defined by resilient members 48 and complementary interfaces 50 is also applicable to the other embodiments such as those illustrated in Figures 2 to 4 and 9 to 14. A separate biasing means is an optional feature to all of the embodiments.

Figure 1 illustrates retention clips 51 and complementary detents 53. The clips 51 connect the first and second boards 16 and 18 vertically yet allow translational movement of the boards 16, 18 relative to each other in the direction of grid expansion and recovery. Other functionally similar retention means such as integral moulding of the boards with complimentary sliding rails (not shown) may also be used.

The heat-recoverable metal motion transmission means, in the form of the grid 20 is formed from a heat-recoverable shape memory alloy having an austenitic state and a martensitic state.

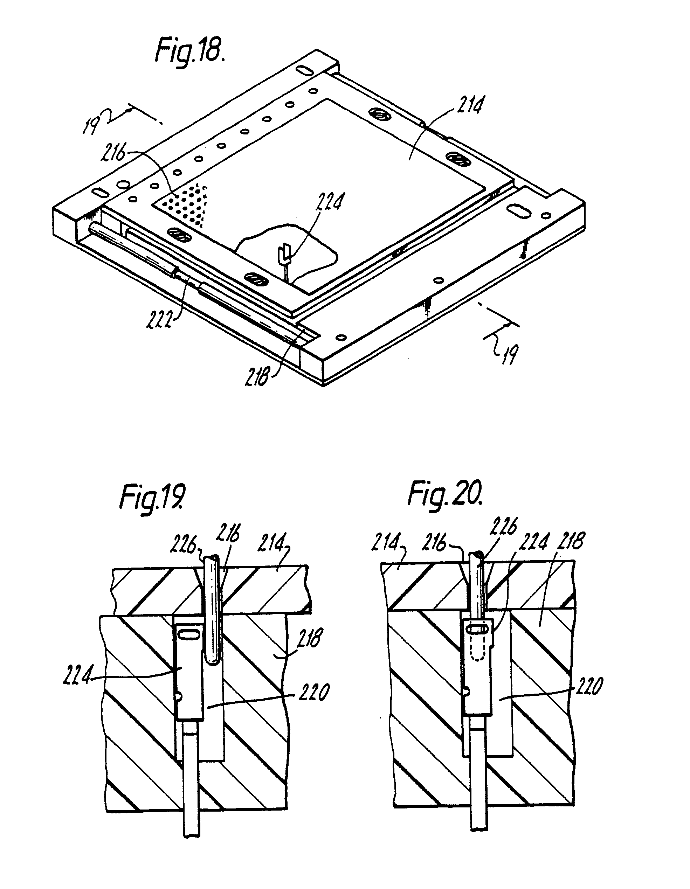

While heat-recoverable metals have been known for some, their use in connecting devices has been limited by the relatively small percent of recoverable deformation they exhibit when they are recovered. The amount of receovery is dependent upon the alloy used, as well as by the means in which it has been expanded or deformed. The recovery is typically limited to 6 to 8 percent strain. Furthermore, those alloys which exhibit the desired heat recoverability are not necessarily themselves excellent electrical conductors, nor do they necessarily exhibit the ability to be readily soldered. The grid 20 of Figure 1, having long webs 30, provides a heat-recoverable metal motion-transmitting means having more extension and more subsequent motion. Similarly, long external motion-transmitting means 222 are disclosed with respect to Figures 18—20.

Referring to Figure 2, the grid 20, particularly the webs 30, are expanded. The grid 20 recovers to its original smaller dimension (Figure 3). This recovery is facilitated by a change from one expanded metallurgical state to another metallurgical state, the change causing movement of the first and second boards 16, 18 relative to each other. This in turn causes engagement between the contact elements 24 and the pins 14.

Motion of the boards 16, 18 relative to each other is accomplished by expanding the grid 20 while it is in its martensitic state and then changing the length of the grid by a change in temperature to its austenitic state. The change in metallurgical state recovers the grid to its nonexpanded dimension. The first and second boards 16 and 18 thus move relative to each other, causing engagement between the contact elements 24 and the pins 14.

To use the properties of a heat-recoverable metal it is necessary to obtain an expanded martensitic state and a recovered austenitic state. The recovered austenitic state is inherent in the material. The expanded martensitic state may be obtained by one of the following three methods.

The first method is to cool the heat-recoverable metal motion transmitting means or grid 20 below its martensitic transformation temperature and then to expand the grid dimensionally by a mechanical means such as the tool 58 or by a separate biasing means. Upon heating, the material will return to its original or nonexpanded austenitic state, overcoming if necessary the separate biasing means.

The second method is to apply a stress alone. Application of sufficient stress will cause a simultaneous expansion of the grid and transformation of the material from its austenitic state to an expanded martensitic state. This type of behaviour of the material is often referred to as its pseudoelastic behavior. However, martensite can be produced by stress only over a limited temperature range above its martensitic transformation temperature. Upon release of the stress, the material will revert to its original non expanded dimension and austenitic state. The grid can be so stressed by use of the tool 58.

The third method is to cool an appropriately trained grid below its martensitic tranformation temperature. Some heat-recoverable alloys after repeated cycling by either of the first two methods above become "trained". An external mechanical means for expansion is no longer required and the "trained" grid will spontaneously expand with cooling alone. Such a phenomena is discussed in *Treatises in Metallurgy* edited by J. F. Tien and J. F. Elliott, 1981, in the chapter titled "Fundamentals of Martensitic Reaction" by M. Cohen and C. M. Wayman. This chapter is incorporated herein by reference. This behavior of the material is often referred to as its "two way" shape memory effect. The motion-transmitting means shown in Figures 1—4, 14—16, 18, 21, and 27—32 may be made from a trained heat-recoverable metal which will reversibly tranform from its recovered austenitic state to its expanded martensitic state upon change in temperature.

Selection of one of the above means will be determined by the specific properties of the alloys and the connector operating conditions. Basically, all of the connectors disclosed herein may be made utilizing a motion-transmitting means of heat-recoverable metal which obtains an expanded martensitic state by any of the three aforementioned methods.

Figure 2 shows in full section view the connector of Figure 1, with the package 12 inserted therein but prior to recovery of the grid 20 which is expanded. It can be seen that the pins 14 of the package 12 extend into the openings 22 without interference with the contact elements 24. No interference means low or zero resulting insertion force. The contact elements 24 are compliant by nature of their shape or their material composition. Specifically, the contact elements 24 are of cantilever beam construction and are shown generally to have a straight section 52 and an inclined section 54. The straight section 52 is associated with the second board 18 and inclined section 54 extends into the openings 22. The lower portion of the straight section 52 is utilized permanently to interconnect the connector with the associated electronics (not shown). The inclined section 54, as can be clearly seen by comparing Figures 2 and 3, is compliant in that it will move or straighten when engaging the pins 14 of the package 12 upon recovery of the grid 20. The compliancy of the contact elements 24 is important in that the contact elements 24 will elastically deform to accommodate dimensional variations in both the package 12 and the connector 10 thus not damaging the pins 14. Such damage could destroy the removability and the reuse of the package 12. Other compliant contact element configurations, for example a bifurcated configuration, could be used (Figures 18 to 20). Other contact element designs which may be attached to either the board 16 or the board 18 can also be used.

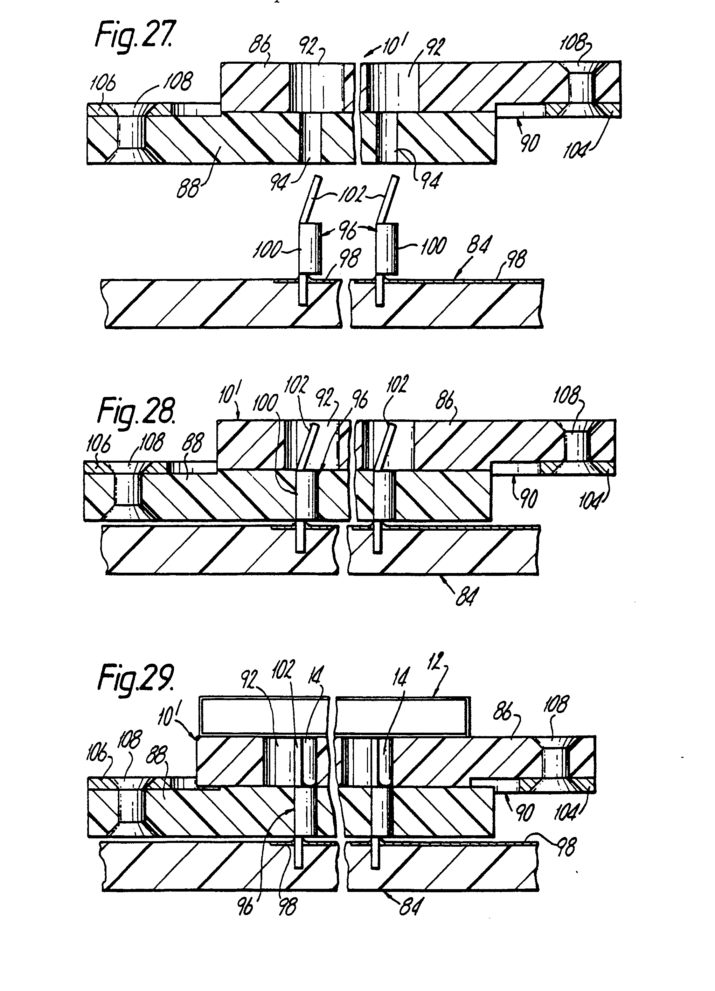

Also the contact elements may be associated with an external substrate (Figures 27 to 29).

Figure 3 illustrates the connector of Figure 2 with the grid 20 in its recovered state. The inclined section 54 of the contact element 24 has been engaged with the pin 14 and has straightened generally into alignment with straight section 52. With the grid 20 recovered, the connector provides a high retention force on package 12.

Figure 4 illustrates an alternative embodiment of connector to that shown in Figures 1 to 3. The second board 18 will accommodate a package 12 having a longer pin 14'. The board 18 is provided with additional pin openings 56 complementary to the openings in the first board 16 into which the longer pins 14' are inserted.

The contact elements 24' are shown be associated with the second board 18 but attachment of the contact elements 24' may be to either board 16 or board 18. Alternatively the boards may be without contact elements (Figures 27 to 29).

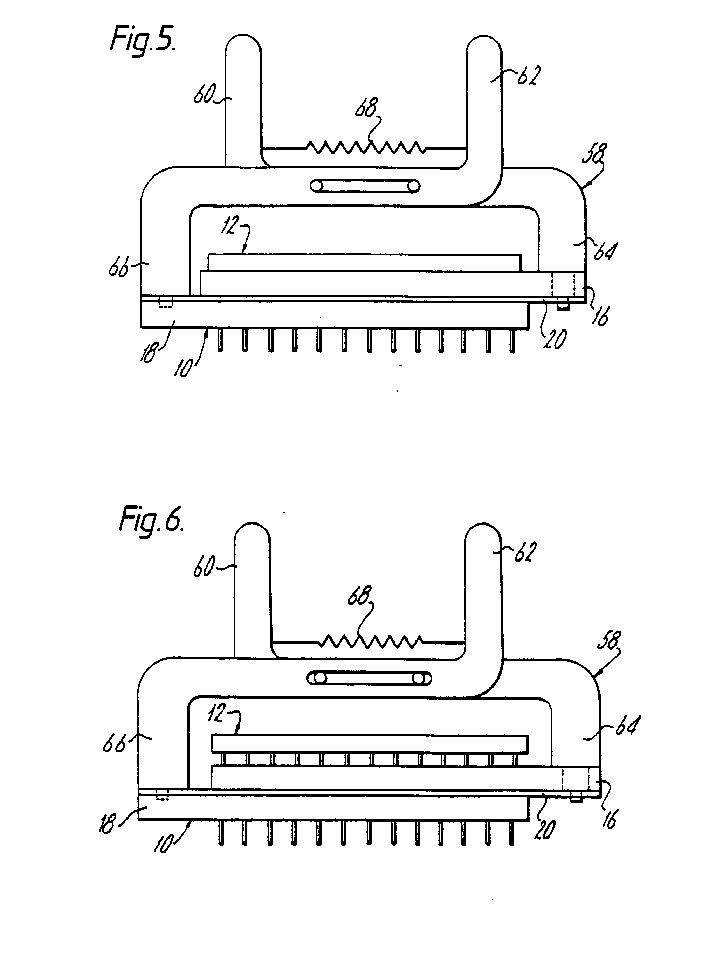

Figures 5 and 6 illustrate the operation of an opening means in the form of a separate removal tool shown generally at 58. The tool 58 comprises first and second members 60 and 62, respectively having connector contact portions 64 and 66, respectively which thermally and mechanically contact the connector 10 to facilitate release of the package 12 after it has been installed and the grid 20 has been recovered. The tool 58 also includes an expansible means 68 in the form a spring tension interconnecting members 60 and 62. In Figure 5, the grid 20 is shown to be recovered and the package 12 has been securely engaged within the connector 10 by relative movement of the boards 16 and 18. Where the grid 20 has previously gone from its martensitic state to its austenitic state and has moved the first and second boards 16, 18 relative to each other, in the austenitic state, the heat-recoverable metal effects high retention force engagement. In this instance, if the grid 20 is returned from its austenitic state to its martensitic state, the grid 20 will weaken but will not, of its own accord, change in dimension. Thus, opening means in the form of a tool 58 (or some optional portion of the connector 10 such as the resilient members 48 and complementary interfaces 50) may be utilized to disengage or open the connector 10. A grid 20 made from a "trained" heat-recoverable metal will expand without the use of a separate tool to disengage by cooling alone.

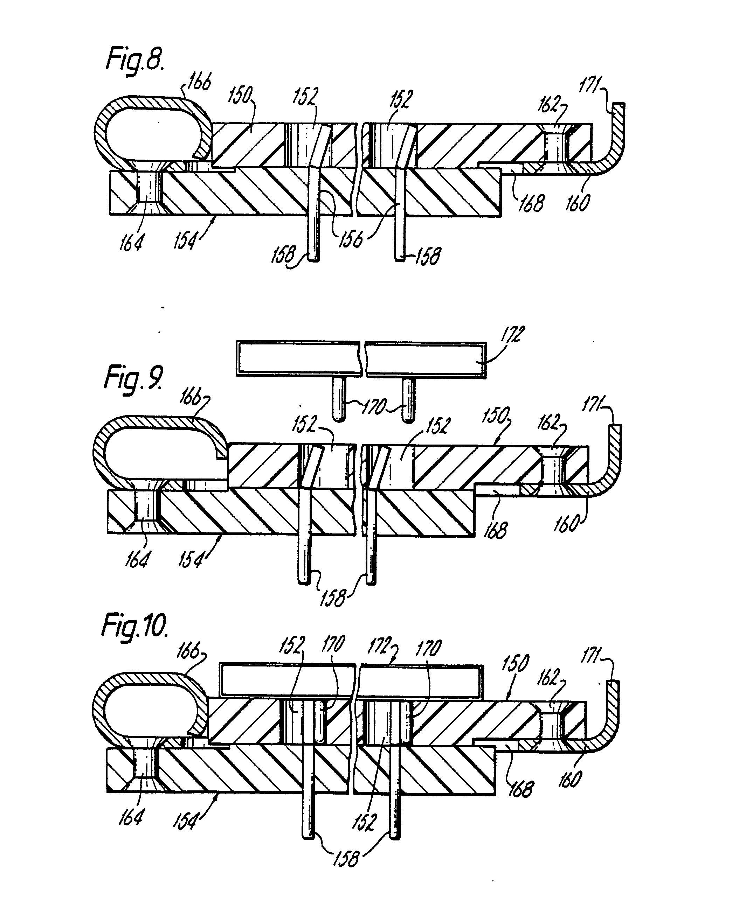

Where the alloy used in the grid 20 is one which is in its martensitic state when relatively cold and which changes to its austenitic state when warmed, removal of the package 12 may be accomplished by applying the tool 58. The tool 58 is cold and through thermal conduction through the portions 64 and 66 will cool the grid 20 causing the grid 20 to transform from its austenitic state to its relaxed martensitic state. Grid cooling fins (Figures 8 to 10) may be provided. The cooling fins extend vertically upward to make further contact with portions 64 and 66. The purpose of the fins is to enhance conductive cooling of the grid 20. The spring 68 of the tool 58 automatically moves the members 60 and 62 relative to each other to expand the grid 20 that has been cooled by portions 64 and 66.

With the grid 20 expanded, the package 12 may be inserted or removed. The package is shown disengaged in Figure 6.

The biasing function of an opening means accomplished by the tool 58 is the same as that achieved by the use of openings in the form of the resilient members 48 and the complementary interfaces 50. Such resilient members operate as a separate biasing means to disengage the pins of the package 12 when the alloy of the grid 20 is cooled by some external means (not shown) such as liquid nitrogen. In either instance, whether an external tool is used or integral biasing means are provided, improved thermal insulation and movement of the grid 20 is enhanced by the use of a coating 70. The coating 70 on webs 30 may be seen in Figure 1. The coating 70 insulates the webs 30 to reduce heat transfer to the boards, thus improving overall heat transfer. The coating 70 also decreases the friction between the grid 20 and the first and second boards 16 and 18. The coating 70 is a fluoropolymer material.

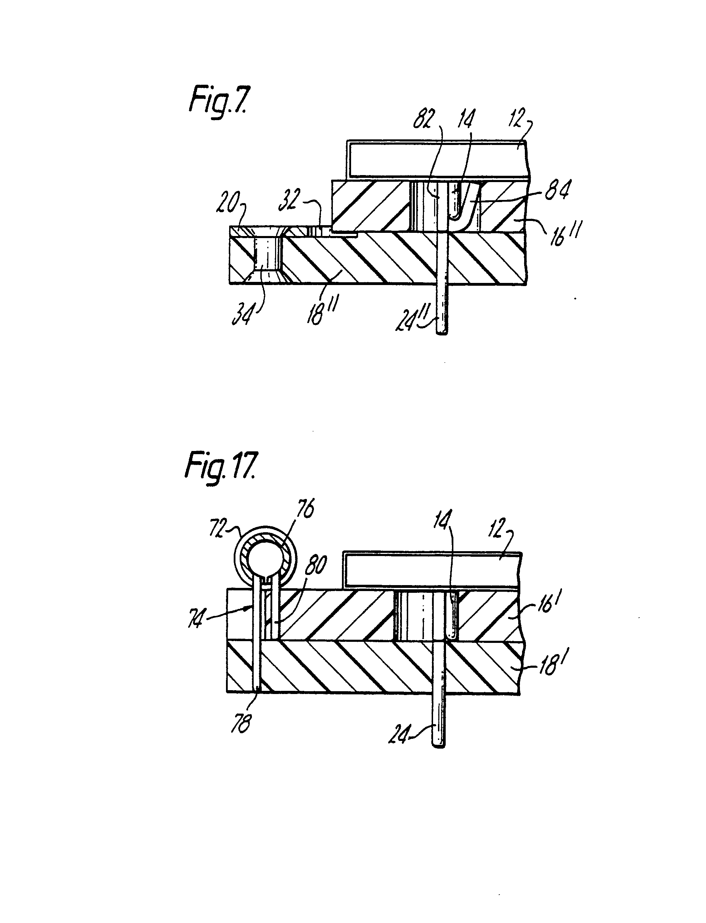

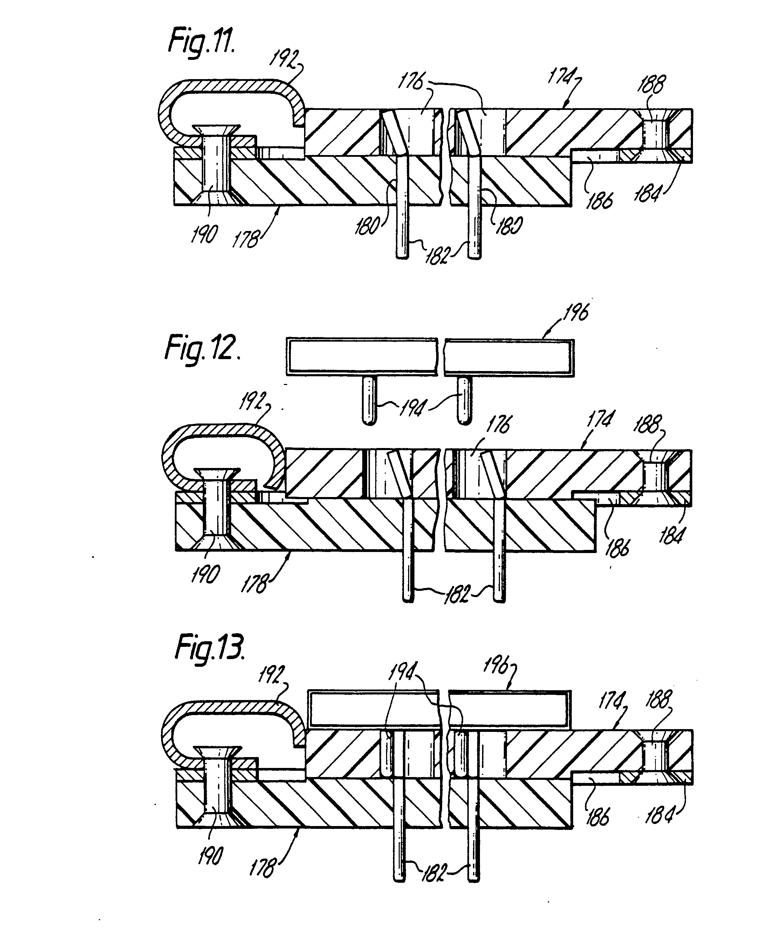

Figure 7 shows another alternative embodiment wherein the opening means comprises forked contacts 24'' having tines 82 and 84. The tines are used both to engage the pins 14 of the package 12 and to bias the boards 16'' and 18''. The inclined tine 84 is shown in contact with the board 16'' to bias the board 16'' relative to the board 18''. The connector is shown in the open condition where the grid 20' has been expanded while in its weakened martensitic state. Grid 20' when warmed, recovers, overcoming the biasing of the tine 84 and causing the capture of the pin 14 between itself and the tine 82. (The forked contacts 24'' may also be used in conjunction with the embodiments illustrated in Figures 27 to 32). The contact is shown biasing the grid 20 open. It is possible to reverse the biasing direction such that the contact biases the connector closed and the motion-transmitting means is used to open the connector (Figures 11 to 13).

Figure 8 illustrates a connector having a first board 150 having a plurality of openings 152 formed therethrough and a second board 154 having a plurality of openings 156 formed therethrough, the second board 154 being mounted generally parallel to the first board 150, and the openings 152 in the first board being complementary to the openings 156 in the second board. Contact elements 158 are connected to the board 154, and occupy the openings 156. The contact elements may instead by connected to the board 150. A motion-transmitting means 160 of heat-recoverable metal is connected to the first board 150 by mechanical means 162 in the form of a rivet. The other end of motion-transmitting means 160 is connected to the second board 154 by a mechanical means 164, also in the form of a rivet, thus interconnecting the first and second boards to move the boards relative to each other. The connector further includes opening means contacting said boards to bias the first board relative to the second board to disengage insertable elements that may be inserted into the complementary openings of the first board when

**0 102 180**

the heat-recoverable metal goes from its austenitic to its martensitic state. The opening means comprises a separate biasing means in the form of a spring-like member 166 which shifts the first board 150 relative to the board 154 (Figure 9).

The biasing means 166 may be a separate spring or may be a continuation of the heat-recoverable metal used as the motion-transmitting means 160. In this regard, the biasing means 166 must retain sufficient spring-like character to move the boards relative to each other to open the connector, as shown in Figure 9. In Figures 8 to 10 the motion-transmitting means 160 is in the form of a grid having openings 168. The grid is provided with an extending fin 171 which may be cooled to cause the heat-recoverable metal to go from its austenitic state to its martensitic state, thus opening the connector. To retain sufficient spring-like character, the biasing means 166 must remain in its austenitic state.

Figure 9 illustrates the connector in the open position wherein the biasing means 166 has moved the first board 150 to expose openings 152 for insertion of insertable elements 170 in the form of pins 170 of an array package 172 into the openings 152.

In Figure 10 the motion-transmitting means has changed from its martensitic state to its stronger austenitic state, recovering to its non-expanded dimension, thus moving the boards relative to each other to force the contact elements 158 into engagement with the pins 170.

Figures 11 to 13 illustrate a further alternative embodiment of connector. In this embodiment the motion-transmitting means of heat-recoverable metal causes disengagement between the insertable elements and the complementary openings of at least one of the boards when the metal transforms from its martensitic to its austenitic state.

In Figure 11, the first board 174, having a plurality of openings 176 therethrough, is mounted generally parallel to the second board 178, having openings 180 formed therethrough, said openings 180 being complementary to the openings 176. Contacts 182 are provided. These are optional. A motion-transmitting means 184 of heat-recoverable metal, in the form of a grid having at least one slot 186, interconnects the first board 174 and the second board 178. Motion-transmitting means 184 is connected to the first board 174 by mechanical means in the form of rivets 188 and to the second board 178 by mechanical means in the form of rivets 190. A closing means 192 is provided. The closing means 192 contacts the first board 174 at the end of first board 174 and is fastened to the second board 178 by the same mechanical means, that is by one of the rivets 190. The closing means 192 therefore interacts between first board 174 and the second board 178 to bias the first board 174 relative to the second board 178 to engage the insertable elements which are pins 198 of an array package 196. The closing means 192 is a spring-like member which expands as can be seen by comparing Figures 12 and 13. The closing means may be incorporated with the contacts themselves. In this case, contacts (not shown) similar to the ones shown in Figure 7 may be used where each contact inherently grips a complementary insertable element to make electrical and mechanical contact. In such an embodiment the motion-transmitting means would open the connector by arranging for the relative motion of the boards to overcome the closing force of the contacts.

The motion-transmitting means 184 of heat-recoverable metal, having a martensitic state and an austenitic state, will open the connector when changed from its martensitic state to its austenitic state, i.e., when recovering to its non-expanded dimension, thus moving the boards (Figures 11 and 12). The closing means 192 will expand the motion-transmitting means when the motion-transmitting means is cooled, returning it to its weakened martensitic state, thus closing the connector.

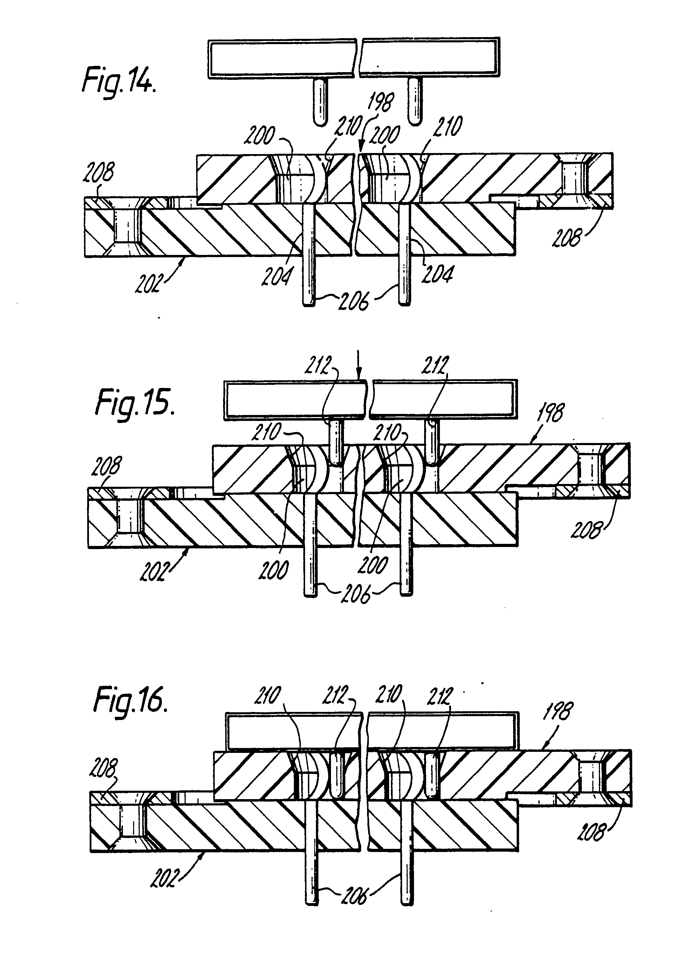

Figures 14 to 16 illustrate yet another embodiment of connector wherein the connector further includes opening means to bias the first board relative to the second board. One of the boards is provided with opening means in the form of inclined contact surfaces complementary to the openings in the board, the surfaces defining a means for translating and amplifying the insertion force of insertable elements when inserted into the openings to bias the first board relative to the second board when the heat-recoverable metal is in its martensitic state, expanding the heat-recoverable metal motion-transmitting means.

The connector comprises a first board 198 having a plurality of openings 200 formed therethrough and a second board 202 having a plurality of openings 204 formed therethrough. The second board is mounted generally parallel to the first board, the openings 200 of the first board 198 being complementary to the openings 204 in the second board 202. Contacts 206 (optional) occupy the openings 204 in the second board 202. A motion-transmitting means 208 of heat-recoverable metal, again having a martensitic state and an austenitic state, interconnects the first and second boards to move the boards relative to each other, to close the connector. One of the boards, in this case the first board 198, is provided with inclined surfaces 210 which are complementary to the openings 200, the surfaces 210 defining a means for translating and amplifying the insertion force of the insertable elements 212. This can be seen more clearly in Figure 15, where the elements 212 are inserted into the openings 200 to bias the first board 198 relative to the second board 202 when the heat-recoverable metal is in its martensitic state, expanding said heat-recoverable metal motion-transmitting means 208. The motion-transmitting means 208 is connected to the first and second boards by mechanical means as discussed earlier.

Figure 17 illustrates yet another embodiment wherein the heat-recoverable metal motion-transmitting means comprises a heat-recoverable metal ring 72 which completely encircles an opening means comprising biasing means in the form of a spring C-ring assembly noted generally at 74. Figure 7 is a cross-sectional side view of this embodiment. It is understood that spring C-ring assembly 74 extends substantially across the width of a first board 16' and that more than one heat-recoverable metal ring 72 may be provided along the axial length of the spring C-ring assembly 74. Spring C-ring assembly 74 comprises a generally cylindrical spring body portion 76, extending transversely across the surface of the first board 16', and depending pegs 78 and 80 which are attached to the boards 16' and 18'. The peg 80 is secured to the first board 16' and the peg 78 is secured to the second board 18' through an oversized opening in the first board 16'. A plurality of pegs 78 and 80 may be used extending transversely across the surfaces of the boards.

The heat-recoverable metal ring 72 is shown in its recovered or austenitic state, wherein it has compressed or squeezed spring C-ring assembly 74 so as to move the first board 16' relative to the second board 18' forcing the pins 14 into secure engagement with the contact member 24. The contact member 24 may be associated with an external substrate. If the heat-recoverable metal ring 72 were, as described with respect to the other embodiments, cooled so as to return to its weakened or martensitic state, then the spring force exerted by spring C-ring assembly 74 and as transmitted by the pegs 78 and 80 would overcome the compressive forces of heat-recoverable metal ring 72, radially expanding the heat-recoverable metal ring 72, moving the boards relative to each other and disengaging or opening the connector.

Figures 18 to 20 disclose yet another embodiment wherein the motion-transmitting means is mounted outside the boards.

A first board 214 has a plurality of openings 216 formed therethrough. Also provided is a second board 218 having a plurality of openings 220 formed therethrough, the second board 218 being mounted generally parallel to the first board 214, the openings 216 in the first board 214 being complementary to the openings 220 in the second board 218. A motion-transmitting means 222 of heat-recoverable metal interconnects the first board 214 to the second board 218 to move the boards relative to each other, the motion-transmitting means being expanded dimensionally while in its martensitic state, a change from its martensitic to its austenitic state recovering the means to its non-expanded dimension, thus moving the boards relative to each other.

The motion-transmitting means 222 is nonuniform in cross-section to optimise the heat-recoverable strain behaviour of the heat-recoverable metal. The motion-transmitting means is a linear element, the central portion thereof, having a smaller axial cross-section. The purpose of the smaller cross-section is to define and to limit the area undergoing expansion during the austenite to martensite transition, thus enabling the motion-transmitting means to operate at the most efficient strain range for a particular application. It is understood that although a rod or bar-like member is shown, the motion-transmitting means may be of various general configuration for example a tube having a drawn-down centre portion, or a rectangular bar having a reduced centre cross-section. In this embodiment the motion-transmitting means is used to close the connector. A trained heat-recoverable metal which will reversibly transform from its recovered austenitic state to its expanded martensitic state upon a change in temperature may be used to disengage the insertable elements. Optionally, a separate opening means may be provided. In addition, it is also possible to vary the cross-section in more than one area for optimum thermal access.

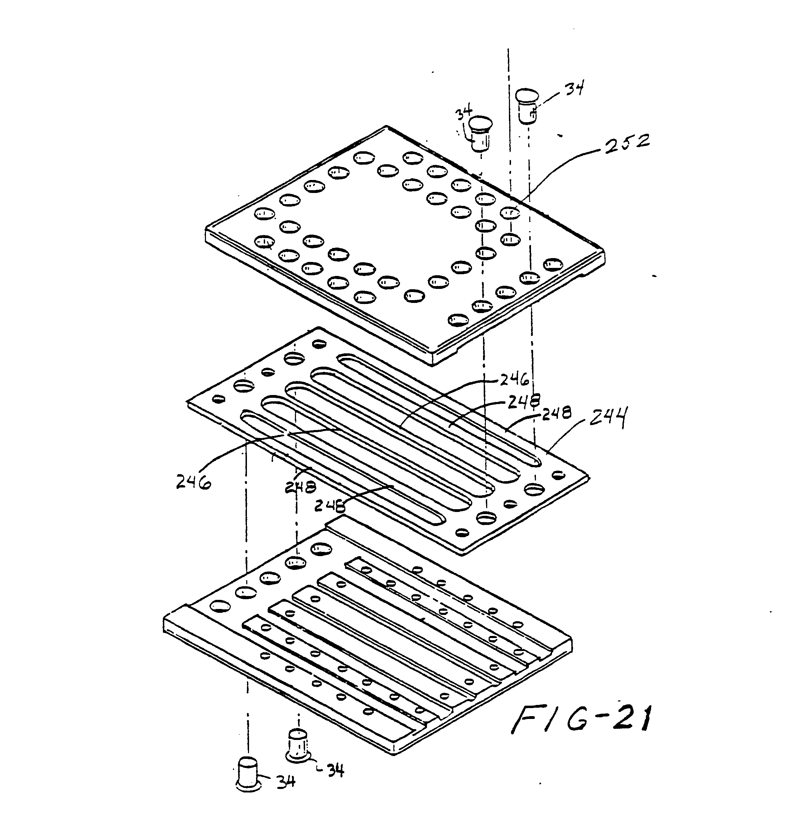

Figures 19 and 20 illustrate a bifurcated type of contact 224 inserted into the opening 220 of the second board 218. The contact 224 can slidingly receive the insertable element 226 (Figure 18). Electrical contact is provided by the contact 226 alone. The motion-transmitting means 222 merely moves the insertable element 226 into the contact 224. The bifurcated contact 224 provides all the mating force required to ensure electrical/mechanical integrity. The contact force is determined by the bifurcated contacts themselves rather than in the embodiment of Figure 1 where the contact force is a function of the remaining stress in the motion-transmitting means.

Figure 21 illustrates yet another embodiment wherein the motion-transmitting means may be of various cross-section to promote even stress distribution within the motion-transmitting means. The connector is substantially identical to that described with reference to Figurs 1 to 3 with the exception that the motion-transmitting means is in the form of a grid 244 having webs of different cross-section. The grid 244 has webs 246 of small cross-section and webs 248 of relatively larger cross-section. The webs of larger cross-section correspond to the areas of the array package with the greater number of pins; conversely, the webs of smaller cross section correspond to the areas of the array package with the fewer number of pins. This acts to promote uniform stress distribution in the grid and with respect to the mating forces distributed over the array package. The greater the number of insertable elements, the larger the corresponding cross-sectional area of the web.

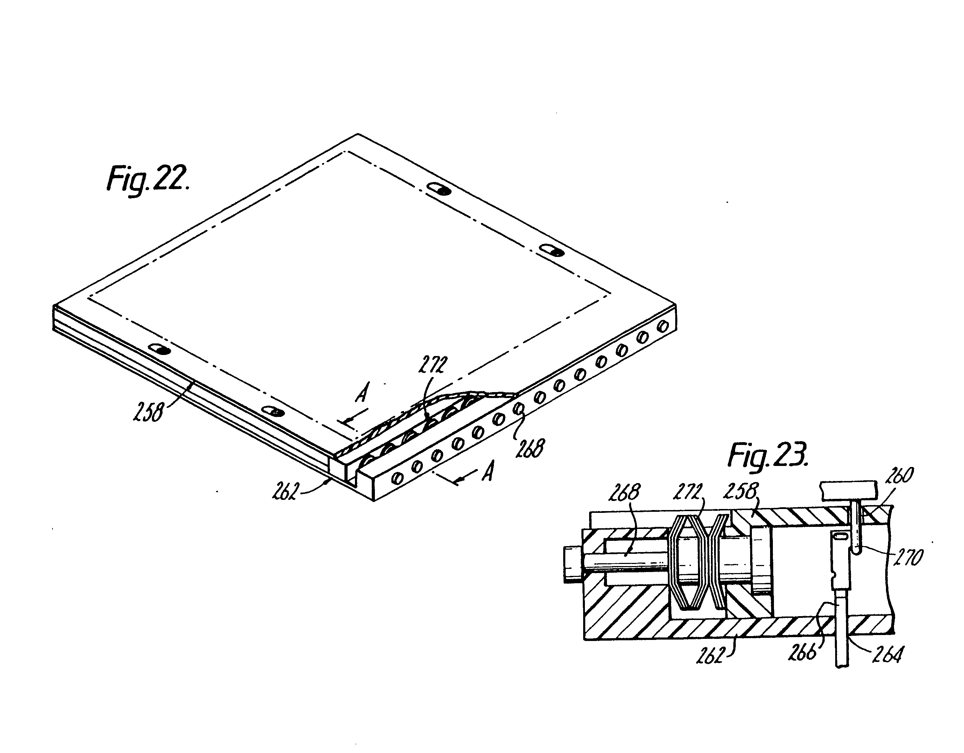

Figures 22 to 26 illustrate two embodiments of connector wherein the motion-transmitting means is a linear element and wherein an additional spring-like member is mounted concentrically with respect to the linear element.

Figure 23 illustrates a first board 258 having openings 260 therethrough and a second board 262 having openings 264 therethrough. Contact elements 266 are shown to occupy the openings 264. A motion-transmitting means 268 interconnects the first board 258 and the second board 262. The motion-transmitting means ~268 is a linear element in the form of a turned-down rod or bar of heat-recoverable metal. The motion-transmitting means 268 recovers to move the insertable elements 270 into engagement with the contacts 266. The opening means 272 is in the form of concentrically mounted spring-like member (Bellville washers) which oppose but are overridden by the recovery of the motion-transmitting means 268.

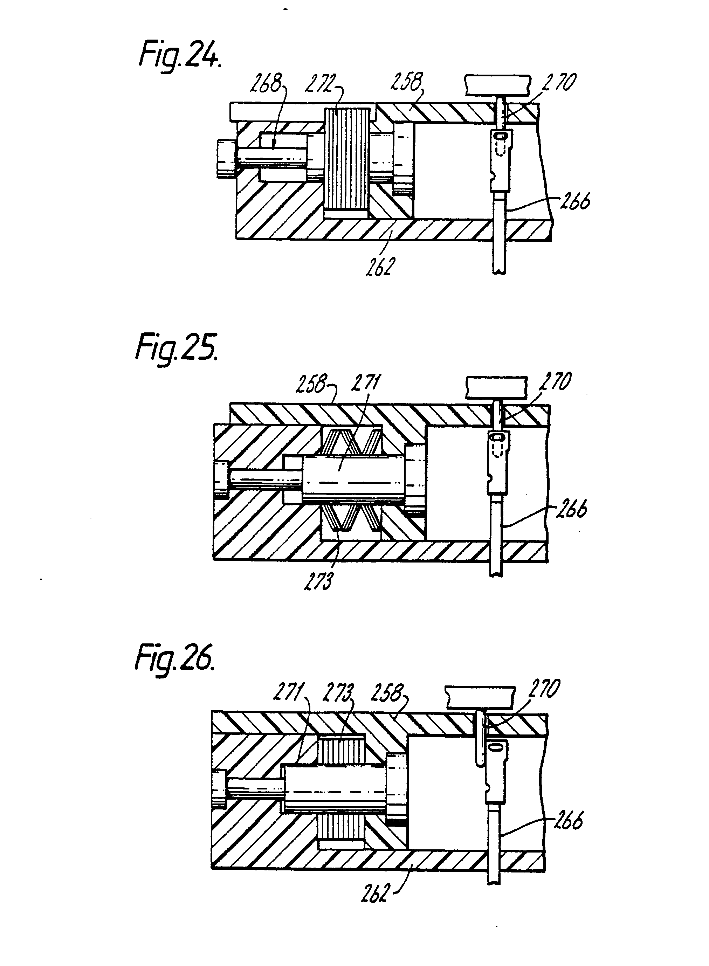

Figures 25 and 26 illustrate the opposite phenomena wherein the motion-transmitting means 271 recovers to disengage the insertable elements 270 from the contacts 266. Additional closing means 273 in the form of concentrically mounted spring-like members (Bellville washers) oppose but are overridded by the recovery of the motion-transmitting means 271.

Figure 27 illustrates the connector of the instant invention referred to generally at 10'. Connector 10' is positioned over a substrate shown generally at 84 before engagement of the connector 10' with the substrate 84. The connector 10' comprises a first board 86, a second board 88, and a heat-recoverable metal motion-transmitting means in the form of a grid 90 positioned between the boards 86, 88.

The first board 86 contains a plurality of openings 92 formed therethrough which are complementary in number and array to the openings 94 of the second board 88.

The substrate 84 includes contact elements 96 which are mechanically and electrically connected to circuit conductors 98, which are shown to be printed circuit on the surface of substrate 84. The contact elements 96 are designed to be compliant relative to the pins 14 of an array package 12.

The contact elements 96 have a generally straight section 100 and an inclined section 102. The straight section 100 is associated with the openings 94 in the second board 88, and the inclined section 102 extends into the openings 92 in the first board 86 (Figure 28). The lower portion of the straight section 100 is used permanently to interconnect the contact element with the surface conductors 98. As compared with the previously discussed embodiments of Figures 1 to 8, the connector 10' lacks contact elements which may be provided by associated electronics in the form of a substrate 84. In this embodiment, compliant contact elements are important but not essential for the successful operation of the connector 10'. Other contact element designs which will interface with the connector 10' and the pins of a package 12 may also be used. As mentioned with respect to Figure 7, the forked contacts 24'' which provide self-biasing, could also be used.

With regard to Figure 28, the openings 94 of the second board 88 provide a press fit with the straight sections 100 and the contact elements 96. The press fit firmly secures the connector 10' to the substrate 84 prior to the engagement of the connector, that is, prior to the interconnection of the pins 14 of a package 12 with the contact elements 96 of a substrate 84. The straight section 100 of the contact element 96 also serves as a lateral anchor for the second board 88.

The heat-recoverable metal motion-transmitting means comprises a grid 90, which is identical in structure and operation to the grid 20 discussed earlier. The grid 90 is positioned between the first board 86 and the second board 88. A first end 104 of the grid 90 is connected to the first board 86, and the second end 106 of the grid 90 is connected to the second board 88 by a fastener means 108. The fastener means 108 are identical to the fastener means 34, discussed earlier. Tool openings (not shown) are provided in the grid 90 and in the first and second boards 86 and 88. The tool openings are identical to the tool openings 36 discussed with respect to the embodiment disclosed in Figure 1. Likewise, the fastener means 108 may comprises hollow rivets (not shown) into which a tool may be inserted.

Figures 27 and 28 show the connector 10' prior to the recovery of the grid 90 which is in its expanded state. Expansion of the grid by external mechanical means or by training the grid has been discussed previously. Figure 29 illustrates the connector 10' with the grid 90 in its recovered state. It can be seen that the inclined sections 102 of the contact elements 96 have engaged with the pins 14 of the package 12. With the grid 90 recovered, the connector 10' provides high retention force on the package 12.

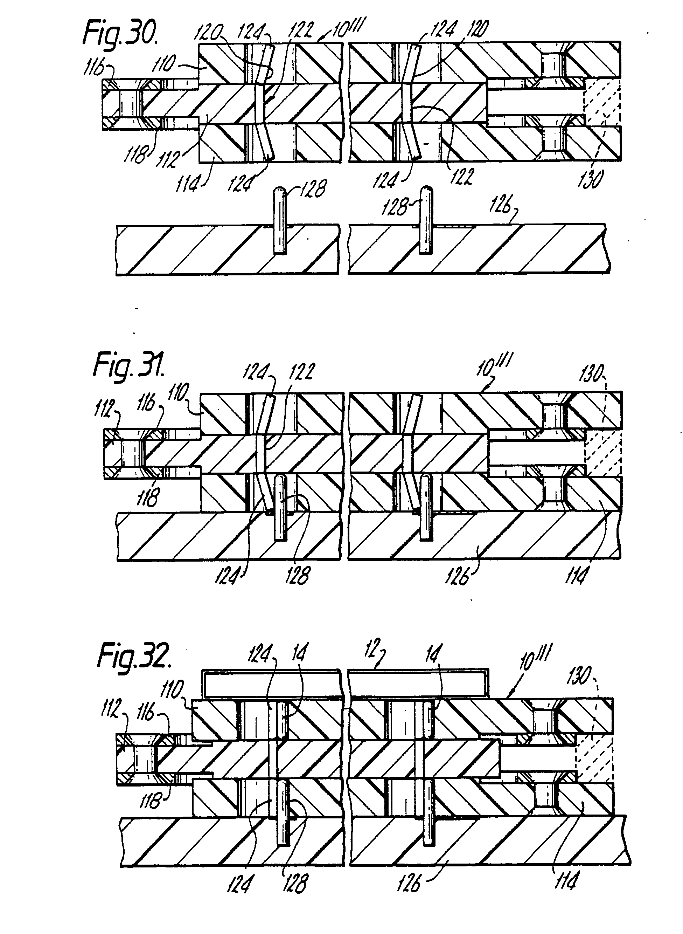

Figures 30 to 32 show yet another embodiment, wherein more than two boards are used and wherein more than one grid may be utilized. With reference to the drawing, a connector, shown generally at 10''', comprises a first board 110, a second board 112, and a third board 114. A heat-recoverable metal motion-transmitting means in the form of a grid 116 interconnects the first board 110 to the second board 112. The heat-recoverable metal motion-transmitting means may also include a second grid 118 which is shown to interconnect the second board 112 and the third board 114.

Contact elements 120 are secured to the second board 112. It can be seen that each of the contact elements 120 has a straight section 122 and inclined end sections 124. The straight section 122 is associated with the second board 112, and the inclined sections 124 extend into the openings in either the first board 110 or the third board 114. The inclined sections are compliant so that they will elastically deflect when engaging the pins.

Figure 30 illustrates the connector 10''' with the grids 116 and 118 in their expanded state. The connector 10''' is positioned above a substrate 126 having pins 128.

Figure 32 illustrates an array package 12, connector 10''', and substrate 126 after engagement of the connector 10'''. The heat-recoverable metal motion-transmitting means in the form of grids 116 and 118 have recovered and the inclined sections 124 of the contact elements 120 have been deflected into general alignment with their respective straight sections 122. With the grids 116 and 118 recovered, the connector provides high retention force on the package 112 and the substrate 126.

The above description assumes that the grids 116 and 118 are recovered simultaneously. The grid 118 may be recovered to engage the substrate 126 before the package 12 is inserted into the connector 10''' (Figures 30 and 31). Once the package 12 is inserted into the connector 10''', i.e., when the pins 14 of the package 12 are inserted into the openings in the board 110, then the grid 116 may be recovered to engage connector 10''' with the package 12.

For simultaneous engagement of the connector 10''' with the package 12 and the substrate 126, the use of a bridging element 130 shown in phantom would make the grids 116 and 118 redundant. Specifically, in an alternative embodiment, a bridging element 130 is used rigidly to interconnect the first board 110 and the second board 114. Only one grid is then necessary to move the first board 110 and the third board 114 with respect to the second board 112. For the sake of illustration, two grids are shown, but the first board 110 may be ridigly secured to the third board 114 with second board 112 positioned therebetween, and a heat-recoverable metal motion-transmitting means may interconnect either the first board 110 and the second board 112 or may interconnect the second board 112 and the third board 114 to move the first board 110 and the third board 114 relative to the second board 112.

**Claims**

1. A connector comprising a first board and a second board each having a plurality of openings formed therethrough, the second board being mounted generally parallel to the first board such that the openings in the first board are complementary to the openings in the second board, and a motion-transmitting means of heat-recoverable metal having a martensitic state and an austenitic state, the means being expanded dimensionally while in its martensitic state, such that a change from its martensitic state to its austenitic state recovering the means to its non-expanded dimension, moves the boards relative to each other, the relative movement of the boards effecting engagement or alternatively disengagement of insertable elements that may be inserted into the complementary openings of the boards.

2. A connector according to claim 1 wherein the motion-transmitting means comprises a grid having webs of material extending between a first and second end of the grid defining at least one slot between the webs, the openings of the first and second boards being positioned so as to define engagement paths between webs, the first end of the grid being connected to the first board and the second end of the grid being connected to the second board.

3. A connector according to claim 1 wherein the motion-transmitting means is mounted externally of the boards.

4. A connector according to claim 3 wherein the motion-transmitting means comprises a linear element.

5. A connector according to any preceding claim wherein the relative movement of the boards, caused by the recovery of the motion-transmitting means, effects engagement of the insertable elements.

6. A connector according to claim 5 wherein the connector also comprises opening means interconnecting the boards to bias the first board relative to the second board to disengage the insertable elements.

7. A connector according to any one of claims 1 to 4, wherein the relative movement of the boards causes disengagement between insertable elements that may be inserted into the complementary openings when the heat-recoverable metal transforms from its austenitic to its martensitic state, the connector also comprises closing means interconnecting the boards to bias the first board rleative to the second board to engage the insertable elements.

8. A connector according to claim 6 wherein the opening means comprises a tool removably connected to the motion transmitting means to expand the motion transmitting means when the heat-recoverable metal goes from its austenitic to its martensitic state.

9. A connector according to claim 6 wherein the opening means and the motion transmitting means are integral, the motion transmitting means being made from a trained heat-recoverable metal.

10. A connector according to claim 6, wherein the opening means comprises a separate biasing means to bias the first board relative to the second board.

11. A connector according to claim 6 wherein the opening means comprises inclined contact surfaces in one of the boards, the surfaces being complementary to the openings in that board, the surfaces defining a means for translating and amplifying the insertion force of insertable elements when inserted into the openings to bias the first board relative to the second board when the heat-recoverable metal is in its martensitic state, expanding the heat-recoverable metal motion transmitting means.

12. A connector according to any preceding claim, comprising contact elements associated with, preferably connected to, one of the boards and complementary to the openings in the other of the boards.

13. A connector according to any preceding claim, comprising a third board having a plurality of openings therethrough, the third board being mounted parallel to the second board such that the openings in the third board are complementary to the openings in the second board, and a second motion transmitting means of heat-recoverable metal to move the second and third boards relative to each other.

14. A connector according to any one of claims 1 to 12, comprising a third board having a plurality of openings formed therethrough, the third board being mounted parallel to the second board such that the openings in the third board are complementary to the openings in the second board, the third board being connected to the first board such that the recovery of the motion transmitting board moves the first and third board relative to the second board.

15. A kit of parts for forming a connector comprising a first board and a second board, each having a plurality of openings formed therethrough, the boards being mountable generally parallel to each other so that the openings in the first board are complementary to those in the second board, and a motion transmitting means of a heat-recoverable metal having a martensitic and an austensitic state, the means being expanded dimensionally while in its martensitic state and being positionable relative to the boards such that a change from the martensitic to the austenitic state of the means recovering the means to its non-expanded dimension, causes the boards to move relative to each other, the relative movement of the boards effecting engagement or alternatively disengagement of insertable elements that may be inserted into the complementary openings of the boards.

## Patentansprüche

1. Verbinder, der eine erste Platte und eine zweite Platte aufweist, die jeweils eine Mehrzahl von Öffnungen haben, die durch dieselben gehen, bei dem die zweite Platte im allgemeinen parallel zu der ersten Platte derart angebracht ist, daß die Öffnungen in der ersten Platte komplementär zu den Öffnungen in der zweiten Platte sind, und bei der eine Bewegungsübertragungseinrichtung aus wärmeerholbarem Metall vorgesehen ist, das einen martensitischen und einen austenitischen Zustand hat, wobei die Einrichtung dimensionsmäßig in ihrem martensitischen Zustand expandierbar ist, so daß bei einer Änderung von ihrem martensitischen Zustand zu ihrem austenitischen Zustand die Einrichtung in ihre nicht-expandierte Dimension rückstellbar ist, die Platten relativ zueinander bewegt und die relative Bewegung der Platten ein Eingreifen oder alternatives Lösen von einführbaren Elementen bewirkt, die in die komplementären Öffnungen der Platten eingeführt werden können.

2. Verbinder nach Anspruch 1, bei dem die Bewegungsübertragungseinrichtung ein Gitter aufweist, das Stege aus Material hat, die sich zwischen einem ersten und einem zweiten Ende des Gitters erstrecken und wenigstens einen Schlitz zwischen den Stegen bilden, bei dem die Öffnungen der ersten und zweiten Platten derart positioniert sind, daß eine Eingriffsbahn zwischen den Stegen gebildet wird und bei dem das erste Ende des Gitters mit der ersten Platte und das zweite Ende des Gitters mit der zweiten Platte verbunden ist.

3. Verbinder nach Anspruch 1, bei dem die Bewegungsübertragungseinrichtung extern von den Platten angebracht ist.

4. Verbinder nach Anspruch 3, bei dem die Bewegungsübertragungseinrichtung ein lineares Element aufweist.

5. Verbinder nach einem der vorangehenden Ansprüche, bei dem die Relativbewegung der Platten, die durch die Rückstellung der Bewegungsübertragungseinrichtung verursacht wird, das Eingreifen der einführbaren Elemente bewirkt.

6. Verbinder nach Anspruch 5, bei dem der Verbinder auch Öffnungseinrichtungen zur Zwischenverbindung der Platten aufweist, um die erste Platte relativ zur zweiten Platte zum Lösen der einführbaren Elemente vorzubelasten.

7. Verbinder nach einem der Ansprüche 1 bis 4, bei dem die Relativbewegung der Platten ein Lösen zwischen den einführbaren Elementen bewirkt, die in die komplementären Öffnungen einführbar sind, wenn das wärmeerholbare Metall sich von seinem austenitischen zu seinem martensitischen Zustand umwandelt, wobei der Verbinder auch eine Verschlußeinrichtung aufweist, die die Platten untereinander verbindet, um die erste Platte relativ zur zweiten Platte vorzubelasten, so daß die einführbaren Elemente in Eingriff kommen.

8. Verbinder nach Anspruch 6, bei dem die Öffnungseinrichtung ein Werkzeug aufweist, die lösbar mit der Bewegungsübertragungseinrichtung verbunden ist, um die Bewegungsübertragungseinrichtung zu expandieren, wenn das wärmeerholbare Metall von seinem austenitischen zu seinem martensitischen Zustand übergeht.

9. Verbinder nach Anspruch 6, bei dem die Öffnungseinrichtung und die Bewegungsübertragungseinrichtung einteilig sind, wobei die Bewegungsübertragungseinrichtung aus einem behandelten wärmeerholbaren Metall besteht.

10. Verbinder nach Anspruch 6, bei dem die Öffnungseinrichtung eine gesonderte Vorbelastungseinrichtung aufweist, um die erste Platte relativ zur zweiten Platte vorzubelasten.

11. Verbinder nach Anspruch 6, bei dem die Öffnungseinrichtung geneigte Kontaktflächen in einer der Platten aufweist, wobei die Flächen komplementär zu den Öffnungen in dieser Platte sind, die Flächen eine Einrichtung zur Übertragung und Verstärkung der Einführungskraft der einführbaren Elemente bildet, wenn diese in die Öffnungen eingeführt werden, um die erste Platte relativ zur zweiten Platte vorzubelasten, wenn das wärmeerholbare Metall sich in seinem martensitischen Zustand befindet und wobei das wärmeerholbare Metall die Bewegungsübertragungseinrichtung expandiert.

12. Verbinder nach einem der vorangehenden Ansprüche, bei dem Kontaktelemente vorgesehen sind, die einer der Platten zugeordnet und vorzugsweise mit dieser verbunden sind und komplementär zu den Öffnungen in der anderen Platte vorgesehen sind.

13. Verbinder nach einem der vorangehenden Ansprüche, bei dem eine dritte Platte vorgesehen ist, die eine Mehrzahl von sie durchsetzenden Öffnungen hat, wobei die dritte Platte parallel zur zweiten Platte derart angeordnet ist, daß die Öffnungen in der dritten Platte komplementär zu den Öffnungen in der zweiten Platte sind, und bei dem eine zweite Bewegungsübertragungseinrichtung aus wärmeerholbarem Metall vorgesehen ist, um die zweite und die dritte Platten relativ zueinander zu bewegen.

14. Verbinder nach einem der Ansprüche 1 bis 12, bei dem eine dritte Platte vorgesehen ist, die eine Mehrzahl von sie durchsetzenden Öffnungen hat, wobei die dritte Platte parallel zur zweiten Platte derart angeordnet ist, daß die Öffnungen in der dritten Platte komplementär zu den Öffnungen in der zweiten Platte sind, und wobei die dritte Platte mit der ersten Platte derart verbunden ist, daß die Rückstellung der Bewegungsübertragungsplatte erste und dritte Platte relativ zur zweiten Platte bewegt.

15. Teilesatz zur Bildung eines Verbinders, der eine erste Platte und eine zweite Platte aufweist, von denen jede eine Mehrzahl von sie durchsetzenden Öffnungen hat, bei dem die Platten im allgemeinen parallel zueinander anbringbar sind, so daß die Öffnungen in der ersten Platte komplementär zu jenen in der zweiten Platte sind, und bei der eine Bewegungsübertragungseinrichtung aus wärmeerholbarem Metall vorgeshen ist, das einen martensitischen und einen austensitischen Zustand hat, wobei die Einrichtung dimensionsmäßig in ihrem martensitischen Zustand expandierbar und relativ zu den Platten derart positionierbar ist, daß eine Änderung vom martensitischen in den austenitischen Zustand der Einrichtung die Einrichtung in ihre nicht-expandierte Dimension zurückstellt, eine Bewegung der Platten relativ zueinander bewirkt und die Relativbewegung der Platten ein Eingreifen oder alternativ ein Lösen von einführbaren Elementen bewirkt, die in die komplementären Öffnungen der Platten eingeführt werden können.

**Revendications**

1. Connecteur caractérisé en ce qu'il comprend une première plaque et une deuxième plaque comportant chacune plusieurs ouvertures formées à travers celles-ci, la deuxième plaque étant montée, d'une façon générale, parallèlement à la première plaque de telle façon que les ouvertures de la première plaque correspondant à celles de la deuxième plaque, et un dispositif de transmission de mouvement en métal à rétablissement thermique, ayant un état martensitique et un état austénitique, ce dispositif augmentant de dimensions dans son état martensitique, de telle sorte qu'un passage de son état martensitique à son état austénitique lui fait reprendre ses dimensions non augmentées et déplace les plaques l'une par rapport à l'autre, ce mouvement relatif des plaques provoquant l'engagement ou le dégagement d'éléments insérables qui peuvent être insérés dans les ouvertures correspondantes des plaques.

2. Connecteur selon la revendication 1, caractérisé en ce que le dispositif de transmission de mouvement comprend une grille comportant des lames qui s'étendent entre une première et une deuxième extrémités de la grille, définissant au moins une fente entre les lames, les ouvertures de la première et de la deuxième plaques étant placées de façon à former des trajets d'engagement entre les lames, la première extrémité de la grille étant connectée à la première plaque et la seconde extrémité de la grille étant connectée à la deuxième plaque.

3. Connecteur selon la revendication 1, caractérisé en ce que le dispositif de transmission de mouvement est monté à l'extérieur des plaques.

4. Connecteur selon la revendication 3, caractérisé en ce que le dispositif de transmission de mouvement comprend un élément linéaire.

5. Connecteur selon l'une quelconque des revendications précédentes, caractérisé en ce que le mouvement relatif des plaques, dû au rétablissement du dispositif de transmission de mouvement, provoque l'engagement des éléments insérables.

6. Connecteur selon la revendication 5, caractérisé en ce qu'il comprend également un dispositif d'ouverture reliant entre elles les plaques pour décaler la première plaque par rapport à la deuxième plaque afin de dégager les éléments insérables.

7. Connecteur selon l'une quelconques des revendications 1 à 4, caractérisé en ce que le mouvement relatif des plaques provoque le dégagement d'éléments insérables qui peuvent être insérés dans les ouvertures complémentaires lorsque le métal à rétablissement thermique passe de son état austénitique à son état martensitique, et en ce qu'il comprend également un dispositif de fermeture reliant entre elles les plaques pour décaler le première plaque par rapport à la deuxième plaque, afin d'engager les éléments insérables.

8. Connecteur selon la revendication 6, caractérisé en ce que le dispositif d'ouverture comprend un outil connecté de façon amovible au dispositif de transmission de mouvement, pour dilater le dispositif de transmission de mouvement lorsque le métal à rétablissement thermique passe de son état austénitique à son état martensitique.

9. Connecteur selon la revendication 6, caractérisé en ce que le dispositif d'ouverture et le dispositif de transmission de mouvement sont solidaires, le dispositif de transmission de mouvement étant fabriqué dans un métal à rétablissement thermique conditionné.

10. Connecteur selon la revendication 6, caractérisé en ce que le dispositif d'ouverture comprend un dispositif de décalage séparé pour décaler la première plaque par rapport à la deuxième plaque.

11. Connecteur selon la revendication 6, caractérisé en ce que le dispositif d'ouverture comprend des surfaces de contact inclinées dans l'une des plaques, ces surfaces correspondant aux ouvertures de ladite plaque et constituant un moyen pour convertir et amplifier la force d'insertion des éléments insérables lorsque ces éléments sont insérés dans les ouvertures pour décaler la première plaque par rapport à la deuxième plaque lorsque le métal à rétablissement thermique est dans son état martensitique, dilatant le dispositif de transmission de mouvement en métal à rétablissement thermique.

12. Connecteur selon l'une quelconque des revendications précédentes, caractérisé en ce qu'il comprend des éléments de contact associés et de préférence connectés à l'une des plaques et correspondant aux ouvertures de l'autre plaque.

13. Connecteur selon l'une quelconque des revendications précédentes, caractérisé en ce qu'il comprend une troisième plaque comprenant plusieurs ouvertures, ladite troisième plaque étant montée parallèlement à la seconde plaque de telle façon que les ouvertures de la troisième plaque correspondent à celles de la seconde plaque, et un deuxième dispositif de transmission de mouvement en métal à rétablissement thermique pour déplacer la seconde et la troisième plaque l'une par rapport à l'autre.

14. Connecteur selon l'une quelconque des revendications 1 à 12, caractérisé en ce qu'il comprend une troisième plaque comportant plusieurs ouvertures, ladite troisième plaque étant montée parallèlement à la seconde plaque de telle façon que les ouvertures de la troisième plaque correspondant à celles de la seconde plaque, ladite troisième plaque étant reliée à la première plaque de telle façon que le rétablissement du dispositif de transmission de mouvement déplace la première et la troisième plaques par rapport à la seconde plaque.

15. Jeu de pièces pour former un connecteur, caractérisé en ce qu'il comprend une première plaque et une seconde plaque comportant chacune plusieurs ouvertures, lesdites plaques pouvant être montées, d'une façon générale, parallèlement par rapport à l'autre de telle façon que les ouvertures de la première plaque correspondent à celles de la deuxième plaque, et un dispositif de transmission de mouvement en métal à rétablissement thermique ayant un état martensitique et un état austénitique, ledit dispositif augmentant de dimensions dans son état martensitique et pouvant être placé par rapport aux plaques de telle façon qu'un passage de l'état martensitique à l'état austénitique dudit dispositif lui fasse reprendre ses dimensions non augmentées et déplace les plaques l'une par rapport à l'autre, ce mouvement relatif des plaques provoquant l'engagement ou le dégagement d'éléments insérables pouvant être insérés dans les ouvertures complémentaires des plaques.

**Fig.1.**

Fig.2.

Fig.3.

Fig.4.

**Fig.5.**

**Fig.6.**

## Fig.7.

## Fig.17.

Fig.8.

Fig.9.

Fig.10.

Fig.11.

Fig.12.

Fig.13.

Fig.14.

Fig.15.

Fig.16.

*Fig.18.*

214

216

224

222

218

19

19

*Fig.19.*

226  216  214

224

218

220

*Fig.20.*

214  216  226  224  218

220

FIG-21

Fig. 22.

Fig. 23.

0 102 180

Fig.24.

Fig.25.

Fig.26.

Fig. 27.

Fig. 28.

Fig. 29.

Fig. 30.

Fig. 31.

Fig. 32.